# EUROPEAN PATENT SPECIFICATION

(11) **EP 2 489 129 B1**
(45) Date of publication and mention of the grant of the patent: **25.02.2015**
(21) Application number: 11714316.4
(22) Date of filing: 14.04.2011
(51) Int. Cl.: G01R 23/10, G01R 23/15, H03M 1/06, H03M 1/14, H03M 1/50, H03M 1/60

(54) **Apparatus and method for measuring the oscillations of an oscillator**
Vorrichtung und Verfahren zur Messung der Oszillationen eines Oszillators
Dispositif et procédé pour la mesure des oscillations d'un oscillateur

(30) Priority: 05.11.2010 US 410758 P; 15.04.2010 DE 102010027829
(43) Date of publication of application: 22.08.2012
(73) Proprietor: Fraunhofer Gesellschaft zur Förderung der angewandten Forschung E.V., 80686 München (DE)
(72) Inventor: VÖLKER, Matthias, 90768 Fürth (DE); BERGS, Joakim, S-59338 Västervik (SE); HAUER, Johann, 91058 Erlangen (DE)
(74) Representative: Hersina, Günter
(86) International application number: PCT/EP2011/055962
(87) International publication number: WO 2011/128419

(56) References cited:
- WATANABE T ET AL: "AN ALL-DIGITAL ANALOG-TO-DIGITAL CONVERTER WITH 12-MUV/LSB USING MOVING-AVERAGE FILTERING", IEEE JOURNAL OF SOLID-STATE CIRCUITS, IEEE SERVICE CENTER, PISCATAWAY, NJ, USA, vol. 38, no. 1, 1 January 2003 (2003-01-01), pages 120-125, XP001223266, ISSN: 0018-9200, DOI: 10.1109/JSSC.2002.806263

## Description

The present invention relates to how the number of oscillations of an oscillator can be reliably determined within a predetermined time interval, and in particular to how an oscillator having a plurality of phase outputs can be efficiently and reliably read out.

In many fields of applications, the determination of the number of oscillations that an oscillator has performed in a specific time interval is important. For example, analog-digital converters having an oscillator with an oscillation frequency depending on a control variable, such as an analog voltage for a current flow are used. A converter result of the analog-digital conversion (A-D conversion) is obtained by counting the number of oscillations of the oscillator in the sample time interval of the A-D converter and outputting the same as digital result. Thereby, the obtainable accuracy, i.e. the resolution of the A-D converter, depends on the frequency of the oscillator. In such an oscillator-based analog-digital converter, generally, the phase change of the oscillator is detected within a reference period. Thereby, for applying such controlled oscillators in analog-digital converters, both oscillators having one output and oscillators having several outputs can be used.

WATANABE T. ET AL: "AN ALL-DIGITAL ANALOG-TO-DIGITAL CONVERTER WITH 12-MUV/LSB USING MOVING-AVERAGE FILTERING", IEEE JOURNAL OF SOLID-STATE CIRCUITS, IEEE SERVICE CENTER, PISCATAWAY, NJ, USA, vol. 38, no. 1, 1 January 2003 (2003-01-01), pages 120-125, XP001223266, ISSN: 0018-9200, DOI: 10.1109/JSSC.2002.806263 presents a compact, high-resolution analog-to-digital converter (ADC) for sensors. The basic structure is a completely digital circuit including a ring-delay-line with delay units (DUs), along with a frequency counter, latch, and encoder. The operating principles are: 1) the delay time of the DU is modulated by the analog-to-digital (A/D) conversion voltage, and 2) the delay pulse passes through a number of DUs within a sampling (= integration) time and the number of DUs through which the delay pulse passes is output as conversion data. Sample holds are unnecessary and a low-pass filter function removes high-frequency noise simultaneously with A/D conversion.

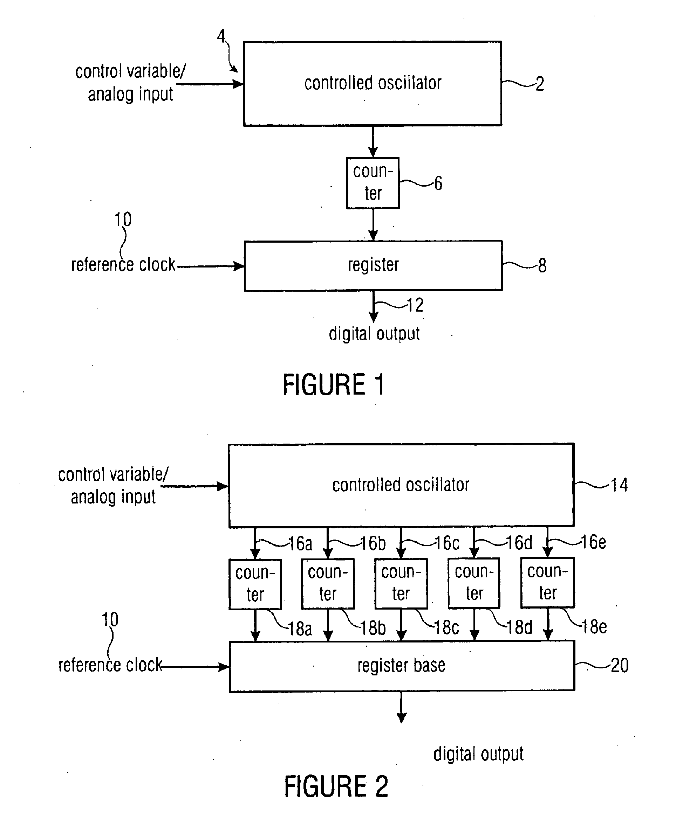

A simple example of such a conventional A-D converter is illustrated in Fig. 1. For the A-D converter concept, an oscillator having an input for a control variable 4 is used. The oscillator 2 changes its oscillation frequency in dependence on the control variable. For analog-digital conversion, analog electric signals can be used as control variable. The frequency of the oscillator 2 can depend, for example, on the voltage at the input of the oscillator or on a current flow. A counter 6 counts the number of oscillations of the oscillator 2 and transfers them to a register 8. If the register is readout with reference clock 10, the overall number of oscillations is available as a result at the register output 12 after every clock.

By subtracting the count known at the end of the previous reference clock, the digital converter result corresponding to the number of oscillations that occurred during the reference clock, i.e. during the sample time of the analog-digital converter is obtained. That is, based on the phase change within a reference period, the oscillator frequency and thus the value of the control variable can be inferred.

In a simple implementation of the counter, where the same counts every zero crossing of the oscillator, the maximum resolution is 180° (phase of the oscillator). That is, at a high required resolution of the converter, the oscillator has to oscillate at a high frequency and the counter has to be able to count at twice the frequency. However, high oscillation frequency and usage of a counter that can operate at a high frequency results in an increase of energy or current consumption.

Further, such a counter has an inherent inaccuracy of a count, since in the case where the reference clock signal and the phase change of the oscillator occur approximately at the same time, no definite statement can be made whether the counter has already been incremented or not. Depending on runtime differences within the circuit and depending on manufacturing tolerances, this can be the case in several constellations and in others not.

An alternative example of an analog-digital converter based on a controllable oscillator is shown in Fig. 2.

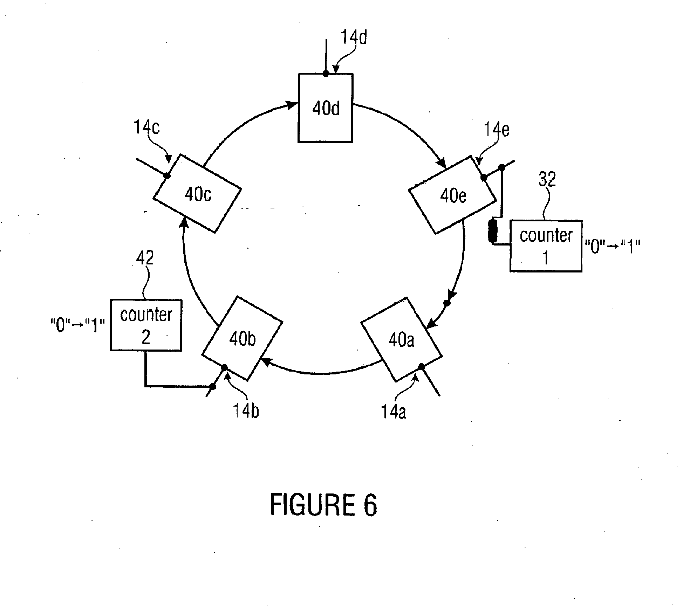

Here, an oscillator 14 having a plurality of outputs 16a-e, referred to as phase outputs below is used. A counter 18a-e is associated with each of the phase outputs 16a-e. The counters are incremented when a predetermined condition occurs at the phase outputs associated with the same. This can, for example, be a specific phase position, or in the case of a ring oscillator, a zero crossing of the signal at the input of the counter. A ring oscillator as could be used in Fig. 2 is illustrated, for example, in Fig. 6. The same will be discussed in more detail below with reference to several embodiments of the invention.

The count of counters 18a-e is written into a register bank 20 operated with the reference clock analogously to the analog-digital converter discussed based on Fig. 1.

If an oscillator for outputting a signal corresponding to the current oscillation phase at the phase output is used, compared to the embodiment shown in Fig. 1, the oscillator frequency can be reduced with identical resolution. If a ring oscillator as shown in Fig. 6 is used, propagation of the signal will be performed within the ring at the high oscillation frequency, but in both cases a counter can be used operating at a frequency lower than the oscillator frequency. However, this does not necessarily result in a reduced overall energy consumption, since the reduced energy consumption of the slower counters is compensated by the higher number of counters. By using several counters, the simultaneous occurrence of phase change and reference signal can partly be detected and corrected by the information from other counters, however, this is paid for by the increased number of counters and the accompanying increased area requirements on the silicon. Obviously, all in all, the circuit shown in Fig. 2 has a higher complexity than the A-D converter of Fig. 1, such that the A-D converter in Fig. 2 also has increased area requirements on the silicon.

As is obvious based on the above-discussed A-D converters, when evaluating the phase changes of an oscillator within one interval, it is important to detect both all possible phase states within an oscillation cycle in an error-free manner, and to reliably determine the number of oscillator cycles or circulations. Thus, for reducing the cost for circuits used for minimizing the oscillations occurring within a predetermined reference interval, it is required to provide more efficient, i.e. less energy and less silicon area consuming circuits for determining the number of oscillations. Integrated analog-digital converters using such apparatuses would also benefit from the accompanying apparatuses.

According to several embodiments of the present invention, an apparatus for determining a measurement value for the oscillations of a controlled oscillator having a plurality of phase outputs is used, that has a reduced number of counters, but at least one. Therefore, embodiments of the invention comprise an evaluation means connected to the plurality of phase outputs as well as the at least one counter. The at least one counter can be connected to a predetermined phase output of the oscillator. Generally, in this application, a reduced number of counters means that the number of counters is lower than a plurality of phase outputs of an oscillator to be evaluated.

In every complete cycle of the oscillator, this is detected by the counter incremented once per cycle. At the end of the reference clock, the evaluation means can determine a relative phase value of the oscillator with respect to that phase value associated with the phase output where the counter is located. By noting the number of circulations or cycles, i.e. the count and the relative phase value, at the end of the reference interval, the evaluation means can determine a measurement value indicating the oscillations that have occurred in the reference interval or for all oscillations since the beginning of a measurement.

Thus, according to the embodiments of the present invention, both the overall number of oscillations or the whole phase change during the reference clock can be determined without having to attach a counter to each of the phase outputs of the oscillator. This enables a strong reduction of complexity of the circuit as well as a reduction of the energy consumption, since the evaluation means only has to perform a comparatively uncomplicated calculation once at each end of a reference clock. In several further embodiments, the security of the readout is additionally increased in that at least one further counter or one further register exists in order to be able to correct possible erroneous counts. These can occur when the counter is read out immediately in the vicinity of a phase transition (when the reference clock ends at this time).

Further embodiments of the present invention will be discussed below with reference to the accompanying drawings.

They show:
- Fig. 1: an example for an analog-digital converter;
- Fig. 2: a further example of an analog-digital converter;
- Fig. 3: an example of an analog-digital converter having one counter;
- Fig. 4: a further embodiment of an analog-digital converter having at least one additional counter;
- Fig. 5: a further embodiment of a A-D converter having one counter and an additional register;
- Fig. 6: an example of a ring oscillator as can be used in the embodiments of Figs. 3 to 5;
- Fig. 7: a specific exemplary configuration of a ring oscillator for usage in the embodiment of Fig. 4; and
- Fig. 8: an example of a method for determining a measurement value for the oscillations of an oscillator that have occurred within a reference interval.

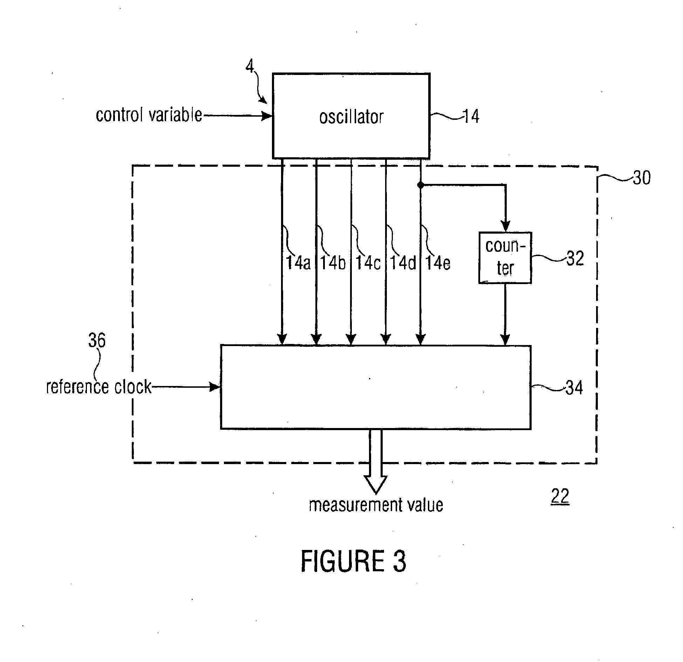

Fig. 3 shows an example of an apparatus for determining a measurement value for the oscillations of an oscillator having a plurality of phase outputs 14a to 14e that have occurred in a reference interval. For clarity reasons, a ring oscillator 14 is shown in Fig. 6 as it could also be used in the example of Fig. 2. However, using exactly such an oscillator is not required for realizing the inventive concept, the same can also be realized with any other oscillator. The oscillator described herein and below merely serves illustration purposes.

The apparatus for determining a measurement value 30 comprises a counter 32 and an evaluation means 34. The counter 32 is connected to a predetermined phase output 14e of the oscillator 14 and is incremented at a predetermined change of state of the phase output 14e. In the embodiment shown in Fig. 3, the counter 32 is connected to the phase output 14e. In alternative embodiments, the counter 32 can be connected to any of the other phase outputs. The predetermined change of state can, for example, be the change of a logic state from "0" to "1" or from "1" to "0" at the phase output 14e of the oscillator.

In the ring oscillator schematically illustrated in Fig 6, as a possible example for an oscillator to be read out, a logic state (i.e. logic "0" or logic "1") is transmitted from an appropriate memory to its adjacent memory at the oscillator clock. Thus, for example, at the first clock, the state stored in the first memory 40a, provided additionally at the first phase output 14a of the oscillator, is transmitted from the first memory 40a to the second memory 40b and latched there until further changes. As indicated in Fig. 6, the predetermined condition where a counter located at the fifth memory 40e is incremented, will be that the signal at the phase output 14e of the memory changes from "0" to "1". Obviously, as alternative criterion, the change from "1" to "0" is also possible. It should again be noted that the oscillator shown in Fig. 6 is merely one of many possible examples of oscillators that can be read out with inventive apparatuses. For simplifying the further discussion and without limiting the generality, however, it is also assumed in the following embodiments that the oscillator to be read out is a ring oscillator of the type shown in Fig. 6. Here, it is merely important that the oscillator has a plurality of phase outputs where changes of state occur, that can be detected in an appropriate manner in order to increment a count in response to a change of state. If in the embodiment shown in Fig. 3 a counter as shown in Fig. 6 is used, the counter 32 is merely incremented in every second circulation. By the inverter in the ring oscillator, it is accomplished that all phase outputs 14a to 14e successively assume the value "1" at first and then successively the value "0". Thus, based on the knowledge of all states at the phase outputs 14a to 14e, the evaluation means 34 can determine a relative phase value of the oscillator with respect to the phase output 14e to which the counter 32 is connected. By using the relative phase value and the count 32, the evaluation means 34 can determine a measurement value reflecting the overall number of phase changes at the phase outputs 14a to 14e that have occurred since the beginning of the measurement. For that purpose, the count stored in the counter 32 is multiplied with an oscillator-specific factor. In the present case, the oscillator-specific factor is ten, since ten changes of state have to occur at the phase outputs 14a-14e until the counter will be incremented once. The relative phase value is added to the product obtained in that manner, to obtain, as a measurement value, the overall number of changes that have occurred at the phase outputs of the oscillator.

By subtracting two successive measurement values determined according to the embodiment in Fig. 3, exactly that number of oscillations would be obtained that has occurred during the duration of one reference clock 36. Generally, the embodiment shown in Fig. 3 of the invention determines an absolute phase value as well as a relative phase value associated with the absolute phase value, such that by combining these two phase values, the number of oscillations can be determined in an error-free manner.

Thus, an A-D converter 22 can be implemented when the apparatus 30 is supplemented with the oscillator 14, initially only illustrated for illustration purposes in Fig. 3.

In other words, the counter 32 continuously includes the cycles of the oscillator. At the end of a reference period (stated by the reference clock 36 at the input of the evaluation means 34) all phase outputs 14a to 14e and the current state of the counter 32 are detected. The exact type of implementation of the counter is arbitrary. The representation of the counts can also be arbitrary (for example, binary, grey code and one-hot). The individual phase registers or memories 14a to 14e can also be realized by different memory circuits (for example, latch, flip-flip, decision latch).

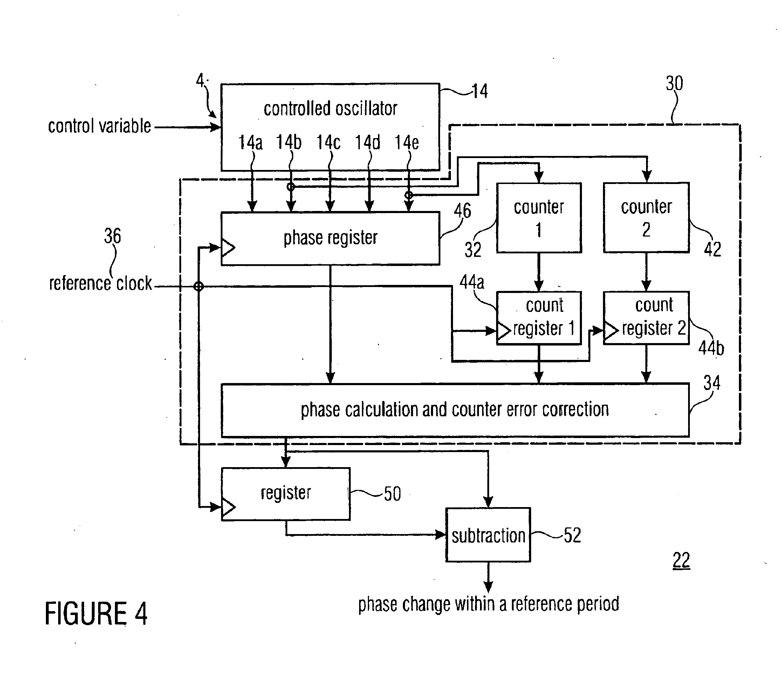

Fig. 4 shows a further embodiment of an apparatus for determining a measurement value for the oscillations of an oscillator 30 that have occurred in a reference interval. The embodiment as shown in Fig. 4 is further suitable to detect and correct possible errors in the counts that can occur when the reference clock ends almost at the same time as a change of state at the phase output 14e of the oscillator 14. As has already been indicated above, a count at the end of the reference clock might be wrong when the phase output where the counter is located experiences a change of state approximately at the same time at the end of the reference clock, such that it is not certain whether the counter, if necessary, has already been incremented or not at the end of the reference clock. For a unified illustration, the components of the apparatus in Fig. 4 that are similar in function or identical to the ones in Fig. 3 have been provided with the same reference numbers, which also applies for the whole application. In addition to the embodiment of Fig. 3, the embodiment in Fig. 4 has a second counter 42 connected to the phase output 14b of the oscillator 14 and that is incremented at a second predetermined change of state (i.e. a change from 0 to 1 or a change from 1 to 0) at the second phase output 14b.

The value of the counter 32 is written into a first count register 44a, and the value of the counter 42 is written into a second counter register 44b. The count registers 44a and 44b are operated with the reference clock 36, such that the values stored in the count registers 44a to 44b are transmitted to the evaluation means 34 at the end of every reference clock. The same applies to the phase register 46 latching the states at the phase outputs 14a to 14e and transmitting the same to the evaluation means 34 at the end of the reference clock. Since the counters are incremented at different times of a full cycle of the oscillator 14, maximally one of the counters can have a possibly erroneous count. This can occur when the reference clock accidentally ends when the predetermined change of state occurs at the phase output associated with the counter. Then, due to manufacturing tolerances or differing line lengths between counter and associated phase output, it can happen that the counter has already been incremented or has just not been incremented. However, in part, this behavior is statistically determined and hence not predictable.

In such a case, as will be described below, the count of the second counter 42 can be used for obtaining an error-free readout result. In other words, in the embodiment shown in Fig. 4, the number of oscillator circulations within one reference period is detected by at least two counters that can be connected to two different phase outputs of the oscillator. In the case where the first counter 32 is incremented at a change of state, which is complementary to that change of state where the second counter 42 is incremented, both counters can even be connected to the same phase output. The counters continuously detect the circulations of the oscillator. At the end of a reference period, the states of all phase outputs 14a-14e and the current state of the two counters 32 and 42 in the registers (phase register, count register 1 and 2) will be detected.

Based on the stored states of the phase outputs, it can be detected, as will be shown below for several exemplary constellations in the form of a table, whether one of the counters could be erroneous due to its simultaneity of phase cycle and end of the reference period (which does not have to be the case). In this case, the other counter is used for evaluation.

The fact that one of the counters might have an erroneous count is indicated by fulfilling an error criterion. The error criterion can generally be considered as being fulfilled when the relative phase value determined by the evaluation means with respect to the corresponding counter corresponds to the resolution obtainable by the oscillator. In other words, the last change of state that has occurred prior to the termination of the reference period has occurred at a phase output adjacent to the phase output associated with the respective counter.

When the error criterion is fulfilled for none of the two counters, i.e. when none of the two counters can be affected by this error, obviously, both can be used equally for evaluation. In order to obtain the same numbers for the number of phase changes in both cases, a common base should be selected. In the present case, this can either be the first counter 32 or the second counter 42. In order to correct the counts of the second counter, for example, to the first counter as reference, the difference of both counters can be detected during processing and stored as correction value. This can be performed, for example, when none of the two counters 32 or 42 can have a potentially erroneous result. In this case, the evaluation means 34 can determine the difference of the two counts and the same can remain stored for further processing. As an alternative to determining such a difference, both counters can also be reset simultaneously at the beginning, in order to set a constant known difference.

Without limiting the generality, it will be assumed in the following examples that the counter 1 (counter 32) serves as reference. That is, counter 32 is evaluated at first. If, however, the error criterion is fulfilled for counter 32, the evaluation will be performed based on counter 42 and the obtained result will then be corrected to counter 32 as reference. In other words, the correct count will be calculated from the value of the second counter, the difference between the counters and the stored phase information. Thus, the absolute value for the number of phase changes or changes of state at the phase outputs of oscillator 14 that have occurred since the beginning of the measurement can be determined based on the current phase and the count of the reference counter, as, for example, also in the embodiment of Fig. 3. By the above-described algorithm, the evaluation means 34 determines the absolute number of changes of state at the phase outputs of the oscillator 14 since the beginning of the measurement. In order to determine the phase-accurate detection of the phase change during a reference period (the duration of a reference clock 36), analogous to Fig. 3, the difference between the measurement value of the current clock and the previous measurement value will be formed.

For this purpose, the apparatus optionally comprises a register 50 for storing the measurement value determined in the previous clock, as well as a subtracter 52 determining the difference of the current and the previous measurement value at the end of each clock.

This can be obtained, for example, as shown in Fig. 4 by controlling the register 50 by the reference clock 36.

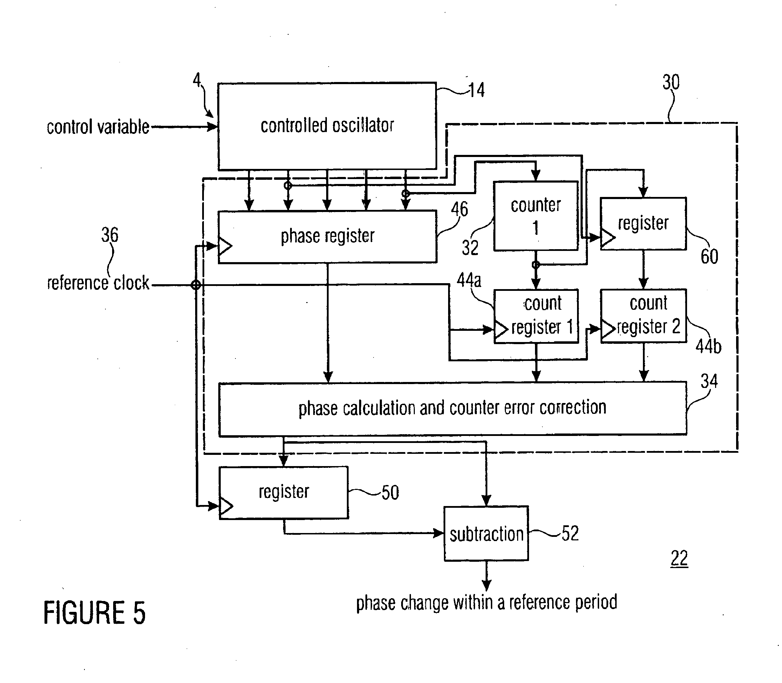

Fig. 5 shows a further embodiment of the invention essentially based on the embodiment shown in Fig. 4. For describing the functionality of the components provided with the same reference numbers, reference is made to the description of Fig. 4. However, in Fig. 5, the second counter 42 is replaced by an additional memory register 60 connected to a second predetermined phase output (here phase output 14b, analogous to the second counter 42 in Fig. 4). Via this connection, the register 60 is controlled, which is additionally connected to the counter 32 such that the count of the counter 32 is transferred to the register 60, when the predetermined condition is fulfilled at the second phase output 14b. It follows that the register 60 obtains the count of the counter 32 at a time when this count can no longer be error-free, since sufficient time has passed since the event incrementing the count of the counter 32.

The other functionality of the embodiment shown in Fig. 5 corresponds to the functionality of Fig. 4.

Using the register 60 results in further savings of a counter while simultaneously maintaining the option of determining correct measurement values in all constellations. By using the register 60 and the wiring illustrated in Fig. 5, energy consumption of the circuit can be additionally reduced since the number of counters is reduced while maintaining full functionality.

All embodiments described above have in common that the error correction algorithm causes relatively little energy consumption, since the same has to perform simple numeric operations only once per reference clock. In this way, even with oscillators having a high number of phase outputs, the silicon area for implementing the embodiments of the inventive apparatuses for evaluating these oscillators can remain low. Above this, the circuit part having to operate at the high oscillator frequency shows little complexity. This means with the inventive embodiments of apparatuses for evaluating oscillators or their associated methods, the number of phase changes of the oscillator can be detected in an error-free manner, wherein by using only one or a low number of counters the size of the circuit and the energy consumption can be significantly reduced compared to previously known solutions.

As has already been mentioned based on the description of Fig. 3, Fig. 6 shows schematically a ring oscillator as it can be used as controlled oscillator that is read out by means of the inventive apparatuses. For example, an analog-digital converter can be implemented where a control variable varies the frequency at which the values of memories 40a-40e are passed on to the respectively adjacent memory.

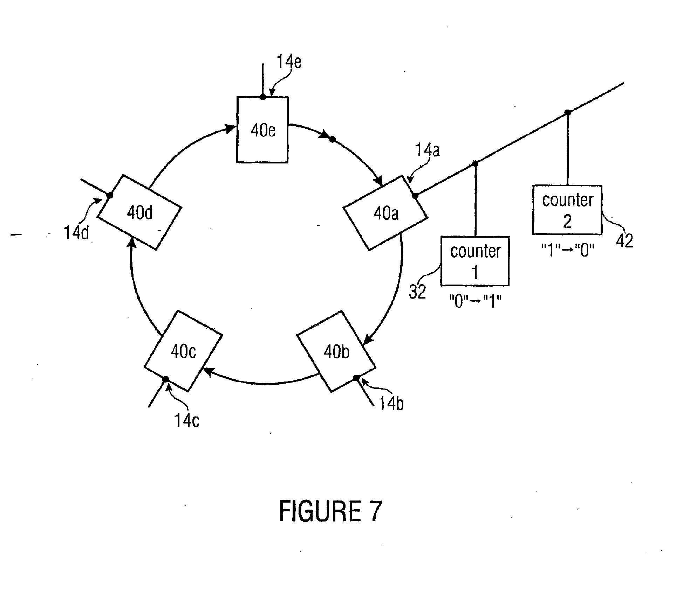

In the example shown in Fig. 7, which will be discussed below in connection with the apparatus for determining the oscillations of the oscillator shown in Fig. 7 that have occurred in a reference interval, both the first counter 32 and the second counter 42 are connected to the phase output 14a of the memory 40a. However, the counter 32 is incremented when the state at the phase output 14a changes from "0" to "1" (rising edge), whereas counter 42 is incremented in the complementary case (change from "1" to "0"). Thus, in a constellation where a potential error can occur, the two counters cannot be changed simultaneously.

The phase registers of memories 40a-40e are each represented by a 1 and a 0 or each include the value "1" or "0". The subsequent tables include the information relevant for error-prevention for eight exemplarily constellations of the just described oscillator as well as the output signal generated by the circuit. Thereby, Table 1 includes both the exemplary states of the individual phase registers 14a-14e associated with the constellations, as well as the counts of counters 32 and 42. Table 2 includes the relative phase values derived there from with respect to the first counter 32 or the second counter 42. Table 3 shows the measurement values for both counters calculated based on the counts and the relative phase value. Table 4 shows the difference of the current output value or measurement value to the previous one and hence the converter result of an analog-digital conversion at a predetermined reference clock.

For explaining the tables, in the following, the configuration underlying line 1 of Tables 1-4 will be discussed briefly, since based on this discussion, the further constellations will be obvious.

**Table 1**

| **Clock** | **Phase Register** | **Count Register 1 (44a)** | **Count Register 2 (44b)** | **Remarks** |
|---|---|---|---|---|
| 1 | 00000 | 4 | 8 | Counter 1 can include an error since the counting operation is imminent, counter 2 should be used |
| 2 | 10000 | 7 | 12 | Counter 1 can include an error since counting has just been performed |
| 3 | 11100 | 12 | 16 | Both counters include a valid value |
| 4 | 11111 | 16 | 20 | Counter 2 can include an error since the counting operation is imminent |
| 5 | 01111 | 22 | 26 | Counter 2 can include an error since it was just active |
| 6 | 00011 | 27 | 31 | Both counters are valid |
| 7 | 11000 | 27 | 31 | Both counters are valid |
| 8 | 00000 | 31 | 35 | Counter 1 can include an error since the counting operation is imminent |

**Table 2**

| **Phase Register** | **Related to Counter 1 (32)** | **Related to Counter 2 (42)** |
|---|---|---|
| 00000 | 9 | 4 |
| 10000 | 0 | 5 |
| 11000 | 1 | 6 |
| 11100 | 2 | 7 |
| 11110 | 3 | 8 |
| 11111 | 4 | 9 |
| 01111 | 5 | 0 |
| 00111 | 6 | 1 |
| 00011 | 7 | 2 |
| 00001 | 8 | 3 |

**Table 3**

| **Clock** | **Calculated Phase (Counter 1)** | **Calculated Phase (Counter 2)** | **Counter difference (D) (Z2+D=Z1)** | **Output Value** |
|---|---|---|---|---|
| 1 | 4*10+9=49 | 8*10+4=84 | -45 | 39 (counter 1 erroneous) |
| 2 | 7*10+0=70 | 12*10+5=125 | -45 | 80 (counter 1 erroneous) |
| 3 | 12*10+2=122 | 16*10+7=167 | -45 (checked) | 122 |
| 4 | 16*10+4=164 | 20*10+9=209 | -45 | 164 |
| 5 | 22*10+5=225 | 26*10+0=260 | -45 | 225 (counter 2 erroneous) |
| 6 | 25*10+7=257 | 30*10+2=302 | -45 (checked) | 257 |
| 7 | 27*10+1=271 | 31*10+6=316 | -45 (checked) | 271 |
| 8 | 31*10+9=319 | 35*10+4=354 | -45 | 309 (counter 1 erroneous) |

**Table 4**

| **Clock** | **Output Signal** |
|---|---|
| 1 | No difference possible |
| 2 | 41 |
| 3 | 42 |
| 4 | 42 |
| 5 | 61 |
| 6 | 32 |
| 7 | 14 |
| 8 | 38 |

At the end of the first clock (end of the first reference period) it is assumed that all phase outputs 14a to 14e are in a state 0. This means that in the next step counter 32 (counter 1) is incremented from "0" to "1 ", since in the next clock, the inverted output (0) of the memory 40e is applied to the input of the first memory 40a, such that the output 14a changes from "0" to "1". As seen in Table 2, this means at the same time that nine clocks have passed since the last increment of the first counter 32, such that the relative phase value derived for this constellation with respect to the first counter 32 is 9. Equivalent considerations have the result that the relative phase value with respect to the second counter 42 is 4. However, enough time (4 clocks) has passed since the last increment of the second counter, such that the error criterion cannot be fulfilled for counter 42 (counter 2), since the relative phase value is higher than the resolution obtainable with the oscillator (one step). However, the error criterion is fulfilled for the first counter, since the relative phase value with respect to the first counter corresponds to the resolution obtainable with the oscillator (1 clock or 1). Thus, counter 2 will be used for the further evaluation.

As seen in Table 3, the calculated measurement value is formed by multiplying the count of the second counter 44b with the oscillator-specific factor 10 (since 10 clocks are required between two increments) and by adding the relative phase value with respect to the second counter (see first line of Table 2, column 3) to this result. The result obtained in this manner is 84 clocks since the beginning of the measurement. The counter difference D (stated in column 4 of Table 3) states the difference of the two counters 32 and 42. The same results from the difference of the counts 1 and 2 at the beginning of the measurement and is assumed to be known. Since counter 2 does not fulfill the error criterion, it results from examining the measurement quantity additionally calculated based on counter 1 that the count of counter 1 is actually erroneous and counter 1 has erroneously already been incremented. In order to relate the measurement value calculated by means of counter 2 to the measurement value of counter 1 as reference, the count difference (the correction value) is added to the result obtained in column 3, in order to obtain the value of 39 clocks stated in column 5 as final measurement value related to counter 1 as reference.

Here, the measurement value stated in column 5 indicates directly the oscillations of an oscillator that have occurred within a reference clock by the apparatus for determining a measurement value. When using the same in an A-D converter, the subtracter 52 will output no converter result in the just-discussed first clock, since there is no previous measurement value. In the further clocks, however, the converter results of the A-D converter stated in Table 4, column 2 will be generated and output by the subtracter 52.

The other lines of Tables 1-4 will be obvious by equivalent considerations.

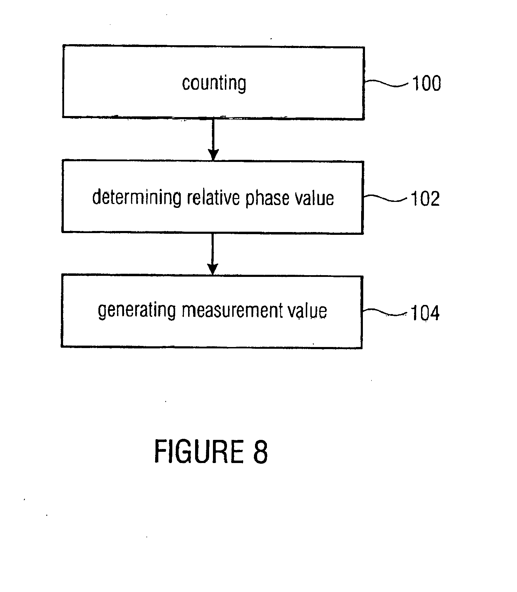

Fig. 8 schematically shows an embodiment of a method for determining a measurement value for the oscillations of an oscillator having a plurality of phase outputs that have occurred in a reference interval. This method comprises the following steps:

In a counting step 100, a counter that is connected to a predetermined phase output of the oscillator is incremented when a predetermined change of state occurs at the phase output.

At the end of a reference interval, in an evaluating step 102, a relative phase value of the oscillator is determined with respect to the phase value associated with the predetermined phase output.

In a step of measurement value generation 104, the measurement value indicating the number of oscillations of an oscillator that have occurred since the beginning of the measurement is determined by using the count at the end of the reference interval and by using the relative phase value.

For obtaining the oscillations of an oscillator that have occurred within the reference interval, the current measurement value can be subtracted from the previous measurement value, i.e. from the measurement value determined at the end of the previous reference interval.

Thus, with the present embodiments of the invention, it is possible to count or determine the oscillations of an oscillator having a plurality of phase outputs in an error-free manner, wherein the used silicon area or the used energy consumption is significantly lower than in previous solutions. Such apparatuses can be used, for example, in oscillator-based analog-digital and time-digital converters. Further fields of application are in phase or delay incremented circuits.

Although several aspects have been described in the context of an apparatus, it is obvious that these aspects also represent a description of the respective method, such that a block or a device of an apparatus can also be considered as a respective method step or feature of a method step. Analogously, aspects that have been described in the context of or as a method step also represent a description of a respective block or detail or feature of a respective apparatus.

Depending on certain implementation requirements, embodiments of the invention can be implemented in hardware or in software. The implementation can be performed by using a digital storage medium, for example floppy disc, DVD, Blu-ray disc, CD, ROM, PROM, EPROM, EEPROM or Flash memory, hard drive or any other magnetic or optical memory, on which the electronically readable control signals are stored that can cooperate or cooperate with a programmable computer system such that the respective method is performed. Hence, the digital memory medium can be computer readable. It follows that several embodiments according to the invention also comprise a data carrier having electronically readable control signals that are able to cooperate with a programmable computer system such that one of the methods described herein will be performed.

Generally, embodiments or parts of embodiments of the present invention can be implemented as computer program product having a program code, wherein the program code is effective to perform one of the methods when the computer program product runs on a computer. The program code can, for example, also be stored on a machine-readable carrier.

Other embodiments comprise the computer program for performing one of the methods described herein, wherein the computer program is stored on a machine-readable carrier.

In other words, an embodiment of the inventive method is a computer program having a program code for performing one of the methods described herein when the computer program runs on a computer. A further embodiment of the inventive methods is hence a data carrier (or a digital storage medium or a computer-readable medium) on which the computer program for performing one of the methods described herein is stored.

Thus, a further embodiment of the inventive method is a data stream or a sequence of signals representing the computer program for performing one of the methods described herein. The data stream or sequence of signals can be configured such that the same can be transferred via a data communication connection, for example via the Internet.

A further embodiment comprises a processing means, for example a computer or programmable logic device configured or adapted to perform one of the methods described herein.

A further embodiment comprises a computer on which the computer program for performing one of the methods described herein is installed.

In several embodiments, a programmable logic device (for example, a field programmable gate array, a FPGA) can be used to perform some or all functionalities of the methods described herein. In some embodiments, a field programmable gate array can cooperate with a microprocessor for performing one of the methods described herein. Generally, in several embodiments, the methods are performed by means of any hardware apparatus. The same can be a universally usable hardware, such as a computer processor (CPU) or hardware specific for the method, such as an ASIC.

The above-described embodiments present merely an illustration of the principles of the present invention. It is obvious that modifications and variations of the arrangements and details described herein will be obvious for a person skilled in the art. Hence, it is intended that the invention is merely limited by the scope of the following claims and not by the specific details that have been presented based on the description and the illustration of the embodiments.

## Claims

1. Apparatus for determining a measurement value for the oscillations of an oscillator (14) having a plurality of phase outputs (14a, ..., 14e) that have occurred in a reference interval, comprising:
a first counter (32) connected to a predetermined phase output (14e) of the oscillator and whose count is incremented at a predetermined change of state of the predetermined phase output;
an evaluation means (34) connected to the plurality of phase outputs (14a, ..., 14e) and the first counter, wherein the evaluation means is implemented to determine, at the end of the reference interval, a relative phase value of the oscillator in relation to the phase value associated with the predetermined phase output; and to determine the measurement value by using the count at the end of the reference interval and by using the relative phase value; and **characterised by** further comprising:
a second counter (42) connected to a second predetermined phase output (14b) of the oscillator (14) and that is incremented at a second predetermined change of state of the second predetermined phase output (14b);
wherein the evaluation means (34) is further connected to the second counter (42) and implemented to determine a second count of the second counter (42) at the end of the reference interval.

2. Apparatus for determining a measurement value for the oscillations of an oscillator (14) having a plurality of phase outputs (14a, ..., 14e) that have occurred in a reference interval, comprising:
a counter (32) connected to a predetermined phase output (14e) of the oscillator and whose count is incremented at a predetermined change of state of the predetermined phase output;
an evaluation means (34) connected to the plurality of phase outputs (14a, ..., 14e) and the counter, wherein the evaluation means is implemented to determine, at the end of the reference interval, a relative phase value of the oscillator in relation to the phase value associated with the predetermined phase output; and to determine the measurement value by using the count at the end of the reference interval and by using the relative phase value; and **characterised by** further comprising:
a register (60) connected to the counter (32) and a second predetermined phase output (14b), such that the register (60) stores the count of the counter at a predetermined change of state of the second predetermined phase output (14b);
wherein the evaluation means (34) is further connected to the register (60) and implemented to use the count of the register (60) as second count at the end of the reference interval.

3. Apparatus according to claim 1 or 2, wherein the evaluation means (34) is implemented to add the relative phase value to a product of the count and an oscillator-specific factor for forming the measurement value.

4. Apparatus according to one of claims 1 to 3, wherein the evaluation means is implemented to determine, at the end of the reference interval, a second relative phase value of the oscillator (14) in relation to a phase value associated with the second predetermined phase output (14b);
wherein the evaluation means (34) is further implemented to determine the measurement value by using the second count and the second relative phase value when an error criterion indicating the possibility of an erroneous count of the counter is fulfilled.

5. Apparatus according to claim 4, wherein the error criterion is fulfilled when the relative phase value corresponds to the resolution obtainable by the oscillator.

6. Apparatus according to claim 4 or 5, wherein the evaluation means (34) is implemented to use a correction value when determining the measurement value taking into account the different phase states when incrementing the counter (32) and the second counter (34).

7. Apparatus according to claim 6, wherein the evaluation means (34) is further implemented to add the second relative phase value and the correction value to a product of the second count and the oscillator-specific factor for forming the measurement value.

8. Apparatus according to claim 6 or 7, wherein the evaluation means (34) is implemented to determine the correction value when an error criterion indicating the possibility of an erroneous count of the respective counter is fulfilled neither for the first counter (32) nor for the second counter (42).

9. Apparatus according to one of claims 1 to 8, further comprising a plurality of registers (46) associated with the plurality of phase outputs (14a, ..., 14e) of the oscillator (14) and implemented to store the state of the phase outputs (14a, ..., 14e).

10. Apparatus according to one of claims 2 to 9, wherein the oscillator-specific factor corresponds to the number of possible phase values of a ring oscillator.

11. Apparatus according to one of claims 2 to 9, wherein the oscillator-specific factor corresponds to twice the number of oscillator stages of a ring oscillator.

12. Apparatus according to one of claims 1 to 11, wherein an overall number of counters is lower than the plurality of phase outputs (14a,..., 14e) connected to the evaluation means.

13. Method for determining a measurement value for the oscillations of an oscillator (14) having a plurality of phase outputs (14a, ..., 14e) that have occurred in a reference interval, comprising:
incrementing a counter connected to a predetermined phase output of the oscillator when a predetermined change of state occurs at the predetermined phase output;
at the end of the reference interval, determining a relative phase value of the oscillator in relation to the phase value associated with the predetermined phase output;
incrementing a second counter connected to a second predetermined phase output (14b) of the oscillator (14) when a second predetermined change of state occurs at the second predetermined phase output (14b); and
determining the measurement value by using the counts of the respective counter at the end of the reference interval and by using the relative phase value.

14. Method for determining a measurement value for the oscillations of an oscillator (14) having a plurality of phase outputs (14a, ..., 14e) that have occurred in a reference interval, comprising:
incrementing a counter connected to a predetermined phase output of the oscillator when a predetermined change of state occurs at the predetermined phase output;
at the end of the reference interval, determining a relative phase value of the oscillator in relation to the phase value associated with the predetermined phase output;
storing in a register (60) the count of the counter at a predetermined change of state of the second predetermined phase output (14b);
determining the measurement value by using the count of the counter at the end of the reference interval, by using the count of the register (60) as second count at the end of the reference interval and by using the relative phase value.
wherein the evaluation means (34) is further connected to the register (60) and implemented to use the count of the register (60) as second count at the end of the reference interval..

15. Analog-digital converter (22) for determining a measurement value for a control variable, comprising:
an oscillator (14) having a plurality of phase outputs whose frequency depends on the control variable; and
an apparatus (30) for determining a measurement value according to one of claims 1 to 12.

16. Analog-digital converter (22) according to claim 15, wherein the apparatus for determining a measurement value is operated by a sample clock of the analog-digital converter as reference clock, wherein the sample clock is lower than the oscillation frequency of the oscillator (14).

17. Analog-digital converter (22) according to claim 15 or 16, wherein the oscillator is a ring oscillator.

18. Analog-digital converter (22) according to one of claims 15 to 17, further comprising:
a register (50) connected to the apparatus (30) for determining a measurement value such that the measurement values of the apparatus for determining a measurement value are stored in the register (50) at the end of each reference clock; and
a subtracter (52) connected to the register (50) and the apparatus for determining a measurement value (30) such that, at the end of each reference clock, the difference of the current measurement value and the measurement value stored in the register (50) is generated at the output of the subtracter (52) as digital sample result for the control variable applied to the oscillator (14) during the reference clock.

## Patentansprüche

1. Vorrichtung zum Bestimmen eines Messwerts für die in einem Referenzintervall aufgetretenen Oszillationen eines Oszillators (14) mit einer Mehrzahl von Phasenausgängen (14a, ..., 14e), mit folgenden Merkmalen:
einem ersten Zähler (32), der mit einem vorbestimmten Phasenausgang (14e) des Oszillators verbunden ist und dessen Zählerstand bei einer vorbestimmten Zustandsänderung des vorbestimmten Phasenausgangs inkrementiert wird;
einer Auswerteeinrichtung (34), die mit der Mehrzahl der Phasenausgänge (14a, ..., 14e) und dem ersten Zähler verbunden ist, wobei die Auswerteeinrichtung dazu ausgebildet ist, am Ende des Referenzintervalls einen relativen Phasenwert des Oszillators relativ zum dem vorbestimmten Phasenausgang zugeordneten Phasenwert zu bestimmen; und den Messwert unter Verwendung des Zählerstands am Ende des Referenzintervalls und unter Verwendung des relativen Phasenwerts zu bestimmen; und **dadurch gekennzeichnet, dass** sie ferner folgende Merkmale aufweist:
einen zweiten Zähler (42), der mit einem zweiten vorbestimmten Phasenausgang (14b) des Oszillators (14) verbunden ist und bei einer zweiten vorbestimmten Zustandsänderung des zweiten vorbestimmten Phasenausgangs (14b) inkrementiert wird;
wobei die Auswerteeinrichtung (34) ferner mit dem zweiten Zähler (42) verbunden und dazu ausgebildet ist, am Ende des Referenzintervalls einen zweiten Zählerstand des zweiten Zählers (42) zu bestimmen.

2. Vorrichtung zum Bestimmen eines Messwerts für die in einem Referenzintervall aufgetretenen Oszillationen eines Oszillators (14) mit einer Mehrzahl von Phasenausgängen (14a, ..., 14e), mit folgenden Merkmalen:
einem Zähler (32), der mit einem vorbestimmten Phasenausgang (14e) des Oszillators verbunden ist und dessen Zählerstand bei einer vorbestimmten Zustandsänderung des vorbestimmten Phasenausgangs inkrementiert wird;
einer Auswerteeinrichtung (34), die mit der Mehrzahl der Phasenausgänge (14a, ..., 14e) und dem Zähler verbunden ist, wobei die Auswerteeinrichtung dazu ausgebildet ist, am Ende des Referenzintervalls einen relativen Phasenwert des Oszillators relativ zum dem vorbestimmten Phasenausgang zugeordneten Phasenwert zu bestimmen; und den Messwert unter Verwendung des Zählerstands am Ende des Referenzintervalls und unter Verwendung des relativen Phasenwerts zu bestimmen; und **dadurch gekennzeichnet, dass** sie ferner folgende Merkmale aufweist:
ein Register (60), das mit dem Zähler (32) und einem zweiten vorbestimmten Phasenausgang (14b) derart verbunden ist, dass das Register (60) bei einer vorbestimmten Zustandsänderung des zweiten vorbestimmten Phasenausgangs (14b) den Zählwert des Zählers speichert;
wobei die Auswerteeinrichtung (34) ferner mit dem Register (60) verbunden und dazu ausgebildet ist, am Ende des Referenzintervalls den Zählwert des Registers (60) als zweiten Zählerstand zu verwenden.

3. Vorrichtung gemäß Anspruch 1 oder 2, bei der die Auswerteeinrichtung (34) dazu ausgebildet ist, zur Bildung des Messwerts den relativen Phasenwert zu einem Produkt aus dem Zählerstand und einem oszillatorspezifischen Faktor zu addieren.

4. Vorrichtung gemäß einem der Ansprüche 1 bis 3, bei der die Auswerteeinrichtung dazu ausgebildet ist, am Ende des Referenzintervalls einen zweiten relativen Phasenwert des Oszillators (14) relativ zum dem zweiten vorbestimmten Phasenausgang (14b) zugeordneten Phasenwert zu bestimmen;
wobei die Auswerteeinrichtung (34) ferner dazu ausgebildet ist, den Messwert unter Verwendung des zweiten Zählerstandes und des zweiten relativen Phasenwertes zu bestimmen, wenn ein Fehlerkriterium erfüllt ist, das die Möglichkeit eines fehlerhaften Zählerstandes des Zählers anzeigt.

5. Vorrichtung gemäß Anspruch 4, bei der das Fehlerkriterium erfüllt ist, wenn der relative Phasenwert der mit dem Oszillator erzielbaren Auflösung entspricht.

6. Vorrichtung gemäß Anspruch 4 oder 5, bei der die Auswerteeinrichtung (34) dazu ausgebildet ist, bei der Bestimmung des Messwerts einen Korrekturwert zu verwenden, der die unterschiedlichen Phasenzustände bei der Inkrementierung des Zählers (32) und des zweiten Zählers (34) berücksichtigt.

7. Vorrichtung gemäß Anspruch 6, bei der die Auswerteeinrichtung (34) ferner dazu ausgebildet ist, zur Bildung des Messwerts den zweiten relativen Phasenwert und den Korrekturwert zu einem Produkt aus dem zweiten Zählerstand und dem oszillatorspezifischen Faktor zu addieren.

8. Vorrichtung gemäß Anspruch 6 oder 7, bei der die Auswerteeinrichtung (34) dazu ausgebildet ist, den Korrekturwert zu bestimmen, wenn weder für den ersten Zähler (32) noch für den zweiten Zähler (42) ein Fehlerkriterium erfüllt ist, dass die Möglichkeit eines fehlerhaften Zählerstandes des jeweiligen Zählers anzeigt.

9. Vorrichtung gemäß einem der Ansprüche 1 bis 8, die ferner eine Mehrzahl von Registern (46) aufweist, die der Mehrzahl von Phasenausgängen (14a, ..., 14e) des Oszillators (14) zugeordnet und dazu ausgebildet sind, den Zustand der Phasenausgänge (14a, ..., 14e) zu speichern.

10. Vorrichtung gemäß einem der Ansprüche 2 bis 9, bei der der oszillatorspezifische Faktor der Anzahl möglicher Phasenwerte eines Ringoszillators entspricht.

11. Vorrichtung gemäß einem der Ansprüche 2 bis 9, bei der der oszillatorspezifische Faktor dem Doppelten der Anzahl von Oszillatorstufen eines Ringoszillators entspricht.

12. Vorrichtung gemäß einem der Ansprüche 1 bis 11, bei der eine Gesamtzahl von Zählern geringer ist als die Mehrzahl von Phasenausgängen (14a, ..., 14e), die mit der Auswerteeinrichtung verbunden sind.

13. Verfahren zur Bestimmung eines Messwerts für die in einem Referenzintervall aufgetretenen Oszillationen eines Oszillators (14) mit einer Mehrzahl von Phasenausgängen (14a, ..., 14e), mit folgenden Schritten:
Inkrementieren eines Zählers, der mit einem vorbestimmten Phasenausgang des Oszillators verbunden ist, wenn an dem vorbestimmten Phasenausgang eine vorbestimmte Zustandsänderung auftritt;
am Ende des Referenzintervalls, Bestimmen eines relativen Phasenwerts des Oszillators relativ zum dem vorbestimmten Phasenausgang zugeordneten Phasenwert;
Inkrementieren eines zweiten Zählers, der mit einem zweiten vorbestimmten Phasenausgang (14b) des Oszillators (14) verbunden ist, wenn an dem zweiten vorbestimmten Phasenausgang (14b) eine zweite vorbestimmte Zustandsänderung auftritt; und
Bestimmen des Messwerts unter Verwendung der Zählerstände des jeweiligen Zählers am Ende des Referenzintervalls und unter Verwendung des relativen Phasenwerts.

14. Verfahren zur Bestimmung eines Messwerts für die in einem Referenzintervall aufgetretenen Oszillationen eines Oszillators (14) mit einer Mehrzahl von Phasenausgängen (14a, ..., 14e), mit folgenden Schritten:
Inkrementieren eines Zählers, der mit einem vorbestimmten Phasenausgang des Oszillators verbunden ist, wenn an dem vorbestimmten Phasenausgang eine vorbestimmte Zustandsänderung auftritt;
am Ende des Referenzintervalls, Bestimmen eines relativen Phasenwerts des Oszillators relativ zum dem vorbestimmten Phasenausgang zugeordneten Phasenwert;
Speichern, in einem Register (60), des Zählwerts des Zählers bei einer vorbestimmten Zustandsänderung des zweiten vorbestimmten Phasenausgangs (14b);
Bestimmen des Messwerts unter Verwendung des Zählerstandes des Zählers am Ende des Referenzintervalls, unter Verwendung des Zählerstandes des Registers (60) als zweiten Zählerstandes am Ende des Referenzintervalls und unter Verwendung des relativen Phasenwerts.
wobei die Auswerteeinrichtung (34) ferner mit dem Register (60) verbunden und dazu ausgebildet ist, am Ende des Referenzintervalls den Zählwert des Registers (60) als zweiten Zählerstand zu verwenden..

15. Analog-Digital-Wandler (22) zur Bestimmung eines Messwerts für eine Steuergröße, mit folgenden Merkmalen:
einem Oszillator (14) mit einer Mehrzahl von Phasenausgängen, dessen Frequenz von der Steuergröße abhängig ist; und
einer Vorrichtung (30) zum Bestimmen eines Messwerts gemäß einem der Ansprüche 1 bis 12.

16. Analog-Digital-Wandler (22) gemäß Anspruch 15, bei dem die Vorrichtung zum Bestimmen eines Messwerts mit einem Sampletakt des Analog-Digital-Wandlers als Referenztakt betrieben wird, wobei der Sampletakt geringer ist als Oszillationsfrequenz des Oszillators (14).

17. Analog-Digital-Wandler (22) gemäß Anspruch 15 oder 16, bei dem der Oszillator ein Ringoszillator ist.

18. Analog-Digital-Wandler (22) gemäß einem der Ansprüche 15 bis 17 , ferner umfassend:
ein Register (50), das mit der Vorrichtung (30) zum Bestimmen eines Messwerts derart verbunden ist, das am Ende jedes Referenztaktes die Messwerte der Vorrichtung zum Bestimmen eines Messwerts im Register (50) gespeichert werden; und
einen Subtrahierer (52), der mit dem Register (50) und der Vorrichtung zum Bestimmen eines Messwerts (30) derart verbunden ist, dass am Ende eines jedes Referenztakts am Ausgang des Subtrahierers (52) die Differenz des aktuellen Messwerts und des im Register (50) gespeicherten Messwerts als digitales Sampleergebnis für die während des Referenztaktes am Oszillator (14) anliegende Steuergröße erzeugt wird.

## Revendications

1. Dispositif pour déterminer une valeur de mesure pour les oscillations d'un oscillateur (14) présentant une pluralité de sorties de phase (14a,..., 14e) qui se sont produites dans un intervalle de référence, comprenant:
un premier compteur (32) connecté à une sortie de phase prédéterminée (14e) de l'oscillateur et dont la quantité est incrémentée à un changement d'état prédéterminé de la sortie de phase prédéterminée;
un moyen d'évaluation (34) connecté à la pluralité de sorties de phase (14a,..., 14e) et au premier compteur, où le moyen d'évaluation est mis en oeuvre pour déterminer, à la fin de l'intervalle de référence, une valeur de phase relative de l'oscillateur par rapport à la valeur de phase associée à la sortie de phase prédéterminée; et pour déterminer la valeur de mesure à l'aide de la quantité à la fin de l'intervalle de référence et à l'aide de la valeur de phase relative; et
**caractérisé par le fait qu'**il comprend par ailleurs:
un deuxième compteur (42) connecté à une deuxième sortie de phase prédéterminée (14b) de l'oscillateur (14) et qui est incrémenté à un deuxième changement d'état prédéterminé de la deuxième sortie de phase prédéterminée (14b);
dans lequel le moyen d'évaluation (34) est par ailleurs connecté au deuxième compteur (42) et mis en oeuvre pour déterminer une deuxième quantité du deuxième compteur (42) à la fin de l'intervalle de référence.

2. Dispositif pour déterminer une valeur de mesure pour les oscillations d'un oscillateur (14) présentant une pluralité de sorties de phase (14a,..., 14e) qui se sont produites dans un intervalle de référence, comprenant:
un compteur (32) connecté à une sortie de phase prédéterminée (14e) de l'oscillateur et dont la quantité est incrémentée à un changement d'état prédéterminé de la sortie de phase prédéterminée;
un moyen d'évaluation (34) connecté à la pluralité de sorties de phase (14a,..., 14e) et au compteur, où le moyen d'évaluation est mis en oeuvre pour déterminer, à la fin de l'intervalle de référence, une valeur de phase relative de l'oscillateur par rapport à la valeur de phase associée à la sortie de phase prédéterminée; et pour déterminer la valeur de mesure à l'aide de la quantité à la fin de l'intervalle de référence et à l'aide de la valeur de phase relative; et
**caractérisé par le fait qu'**il comprend par ailleurs:
un registre (60) connecté au compteur (32) et à une deuxième sortie de phase prédéterminée (14b), de sorte que le registre (60) mémorise la quantité du compteur à un changement d'état prédéterminé de la deuxième sortie de phase prédéterminée (14b);
dans lequel le moyen d'évaluation (34) est par ailleurs connecté au registre (60) et mis en oeuvre pour utiliser la quantité du registre (60) comme deuxième quantité à la fin de l'intervalle de référence.

3. Dispositif selon la revendication 1 ou 2, dans lequel le moyen d'évaluation (34) est mis en oeuvre pour ajouter la valeur de phase relative à un produit de la quantité et d'un facteur spécifique à un oscillateur pour former la valeur de mesure.

4. Dispositif selon l'une des revendications 1 à 3, dans lequel le moyen d'évaluation est mis en oeuvre pour déterminer, à la fin de l'intervalle de référence, une deuxième valeur de phase relative de l'oscillateur (14) par rapport à une valeur de phase associée à la deuxième sortie de phase prédéterminé (14b);
dans lequel le moyen d'évaluation (34) est par ailleurs mis en oeuvre pour déterminer la valeur de mesure à l'aide de la deuxième quantité et de la deuxième valeur de phase relative lorsqu'un critère d'erreur qui indique la possibilité d'une quantité erronée du compteur est rempli.

5. Dispositif selon la revendication 4, dans lequel le critère d'erreur est rempli lorsque la valeur de phase relative correspond à la résolution pouvant être obtenue par l'oscillateur.

6. Dispositif selon la revendication 4 ou 5, dans lequel le moyen d'évaluation (34) est mis en oeuvre pour utiliser une valeur de correction lors de la détermination de la valeur de mesure en tenant compte des différents états de phase lors de l'incrémentation du compteur (32) et du deuxième compteur (34).

7. Dispositif selon la revendication 6, dans lequel le moyen d'évaluation (34) est par ailleurs mis en oeuvre pour ajouter la deuxième valeur de phase relative et la valeur de correction à un produit de la deuxième quantité et du facteur spécifique à l'oscillateur pour former la valeur de mesure.

8. Dispositif selon la revendication 6 ou 7, dans lequel le moyen d'évaluation (34) est mis en oeuvre pour déterminer la valeur de correction lorsqu'un critère d'erreur qui indique la possibilité d'une quantité erronée du compteur respectif n'est rempli ni pour le premier compteur (32), ni pour le deuxième compteur (42).

9. Dispositif selon l'une des revendications 1 à 8, comprenant par ailleurs une pluralité de registres (46) associés à la pluralité de sorties de phase (14a,..., 14e) de l'oscillateur (14) et mis en oeuvre pour mémoriser l'état des sorties de phase (14a.,..., 14e).

10. Dispositif selon l'une des revendications 2 à 9, dans lequel le facteur spécifique à l'oscillateur correspond au nombre de valeurs de phase possibles d'un oscillateur en anneau.

11. Dispositif selon l'une des revendications 2 à 9, dans lequel le facteur spécifique à l'oscillateur correspond à deux fois le nombre d'étages d'oscillateur d'un oscillateur en anneau.

12. Dispositif selon l'une des revendications 1 à 11, dans lequel un nombre total de compteurs est inférieur à la pluralité de sorties de phase (14a,..., 14e) connectées au moyen d'évaluation.

13. Procédé pour déterminer une valeur de mesure pour les oscillations d'un oscillateur (14) présentant une pluralité de sorties de phase (14a,..., 14e) qui se sont produites dans un intervalle de référence, comprenant le fait de:
incrémenter un compteur connecté à une sortie de phase prédéterminée de l'oscillateur lorsqu'il se produit un changement d'état prédéterminé à la sortie de phase prédéterminée;
à la fin de l'intervalle de référence, déterminer une valeur de phase relative de l'oscillateur par rapport à la valeur de phase associée à la sortie de phase prédéterminée;
incrémenter un deuxième compteur connecté à une deuxième sortie de phase prédéterminée (14b) de l'oscillateur (14) lorsqu'il se produit un deuxième changement d'état prédéterminé à la deuxième sortie de phase prédéterminée (14b); et
déterminer la valeur de mesure à l'aide des quantités du compteur respectif à la fin de l'intervalle de référence et à l'aide de la valeur de phase relative.

14. Procédé pour déterminer une valeur de mesure pour les oscillations d'un oscillateur (14) présentant une pluralité de sorties de phase (14a,..., 14e) qui se sont produites dans un intervalle de référence, comprenant le fait de:
incrémenter un compteur connecté à une sortie de phase prédéterminée de l'oscillateur lorsqu'il se produit un changement d'état prédéterminé à la sortie de phase prédéterminée;
à la fin de l'intervalle de référence, déterminer une valeur de phase relative de l'oscillateur par rapport à la valeur de phase associée à la sortie de phase prédéterminée;
mémoriser dans un registre (60) la quantité du compteur à un changement d'état prédéterminé de la deuxième sortie de phase prédéterminée (14b);
déterminer la valeur de mesure à l'aide de la quantité du compteur à la fin de l'intervalle de référence, à l'aide de la quantité du registre (60) comme deuxième quantité à la fin de l'intervalle de référence et à l'aide de la valeur de phase relative,
dans lequel le moyen d'évaluation (34) est par ailleurs connecté au registre (60) et mis en oeuvre pour utiliser la quantité du registre (60) comme deuxième quantité à la fin de l'intervalle de référence.

15. Convertisseur analogique-numérique (22) pour déterminer une valeur de mesure d'une variable de commande, comprenant:
un oscillateur (14) présentant une pluralité de sorties de phases dont la fréquence dépend de la variable de commande; et
un dispositif (30) pour déterminer une valeur de mesure selon l'une des revendications 1 à 12.

16. Convertisseur analogique-numérique (22) selon la revendication 15, dans lequel le dispositif pour déterminer une valeur de mesure est actionné par une horloge d'échantillonnage du convertisseur analogique-numérique comme horloge de référence, dans lequel l'horloge d'échantillonnage est inférieure à la fréquence d'oscillation de l'oscillateur (14).

17. Convertisseur analogique-numérique (22) selon la revendication 15 ou 16, dans lequel l'oscillateur est un oscillateur en anneau.

18. Convertisseur analogique-numérique (22) selon l'une quelconque des revendications 15 à 17, comprenant par ailleurs:
un registre (50) connecté au dispositif (30) pour déterminer une valeur de mesure de sorte que les valeurs de mesure du dispositif pour déterminer une valeur de mesure soient mémorisées dans le registre (50) à la fin de chaque horloge de référence; et
un soustracteur (52) connecté au registre (50) et au dispositif pour déterminer une valeur de mesure (30) de sorte que, à la fin de chaque horloge de référence, la différence entre la valeur de mesure actuelle et la valeur de mesure mémorisée dans le registre (50) soit générée à la sortie du soustracteur (52) comme résultat d'échantillon numérique pour la variable de commande appliquée à l'oscillateur (14) au cours de l'horloge de référence.
